Europäisches Patentamt

European Patent Office

Office européen des brevets

(19)

(11) Numéro de publication: **0 206 879**
**B1**

(12) **FASCICULE DE BREVET EUROPEEN**

(45) Date de publication du fascicule du brevet:
05.09.90

(51) Int. Cl.⁵: **G01R 33/028**

(21) Numéro de dépôt: 86401183.8

(22) Date de dépôt: 03.06.86

(54) Détecteur de champ magnétique à large bande passante en fréquence.

(30) Priorité: 07.06.85 FR 8508665

(43) Date de publication de la demande:
30.12.86 Bulletin 86/52

(45) Mention de la délivrance du brevet:
05.09.90 Bulletin 90/36

(84) Etats contractants désignés:
CH DE GB LI

(56) Documents cités:
EP-A- 0 109 867
US-A- 4 305 785

IEEE TRANSACTIONS ON ELECTROMAGNETIC
COMPATIBILITY, vol.
EMC-16, no. 2, mai 1974, pages 83-89, New York, US;
P.H. DUNCAN JR.: "Analysis of the Moebius loop
magnetic field sensor"
JOURNAL OF PHYSICS E: SCIENTIFIC INSTRUMENTS,
vol. 11, no. 1, janvier 1978, page 43, The Institute of
Physics; D.F. CREIGHTON et al.: "Detecting
geomagnetic pulsations using a solenoid with a ferrite
core"
IEEE TRANSACTIONS ON INSTRUMENTATION AND
MEASUREMENT, vol.
IM-32, no. 1, mars 1983, pages 241-244, IEEE, New York,

(73) Titulaire: COMMISSARIAT A L'ENERGIE ATOMIQUE,
31/33, rue de la Fédération, F-75015 Paris(FR)

(72) Inventeur: Charmet, Paul, 38, rue de la Chapelle,
F-91310 Montlhery(FR)

(74) Mandataire: Mongrédien, André et al, c/o
BREVATOME 25, rue de Ponthieu, F-75008 Paris(FR)

(56) Documents cités: (suite)
US; J.E. LINDSAY JR. et al.: "Distributed parameter
analysis of shielded loops used for wide-band H-field
measurements"

## Description

La présente invention se rapporte à un détecteur de champ magnétique à large bande passante en fréquence.

L'invention s'applique aux mesures de champ magnétique, notamment dans des simulateurs à ligne rayonnant en espace libre, dans des milieux très perturbés par des parasites électromagnétiques et dans des équipements spécifiques soumis par exemple aux perturbations d'un générateur de simulation.

Un détecteur de champ magnétique a de façon connue, pour caractéristiques essentielles, une constante de temps θ fonction de l'inductance propre L du détecteur et de sa résistance de charge $R_c$, θ=L/$R_c$, une bande passante en fréquences limitées par les fréquences de coupure haute $F_h$ et basse $F_b$ du détecteur. La fréquence de coupure basse est proportionnelle à 1/θ Les caractéristiques B et L se déduisent notamment des dimensions géométriques du détecteur.

Les détecteurs de champ magnétique connus de l'art antérieur ont une bande passante en fréquence étroite, le rapport entre la fréquence de coupure haute $F_h$ et la fréquence de coupure basse $F_b$ est inférieure à 10, la fréquence de coupure basse $F_b$ étant de l'ordre de quelques dizaines de MHz. Ces détecteurs de champ magnétique sont dits passifs et différentiateurs. En effet, ils nécessitent pour traiter des fréquences inférieures à leurs fréquences de coupures basses $F_b$, des moyens électroniques complexes permettant d'opérer une intégration du signal délivré par ces détecteurs. Ces derniers sont donc dépendants de sources d'alimentation telles que des batteries ou des piles dont l'autonomie ne dépasse guère 1 heure en raison du fort débit exigé par ces moyens électroniques et de la place limitée réservée à l'alimentation qui doit nécessairement être intégrée dans un blindage pour ne pas être perturbée.

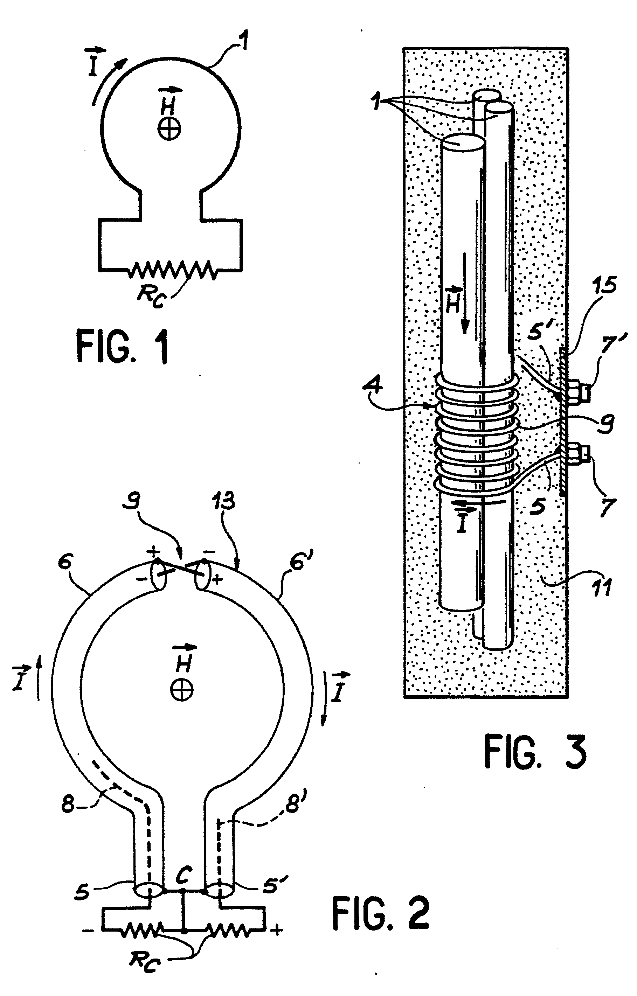

Le principe de base d'un détecteur de champ magnétique $\vec{H}$ repose sur une spire inductive représentée schématiquement sur la figure 1.

Sur cette figure est représenté un conducteur 1 enroulé suivant une spire de longueur ℓ, de surface S et d'inductance propre L. Les extrémités du conducteur 1 sont reliées entre elles par une résistance de charge $R_c$.

Lorsque cette spire est placée dans un champ magnétique $\vec{H}$, il apparaît un courant électrique induit $\vec{I}$ dans le conducteur 1, dont le sens de parcours dépend du sens du champ magnétique $\vec{H}$ et obéit à la règle dite "d'Ampère". La tension de sortie induite $V_S$, prise aux bornes de la résistance de charge $R_c$ est définie par les équations suivantes :

$$V_S = \frac{j\omega\, S\, \mu H\, R_c}{R_c + j\, L\omega} = j\omega\, S\, H \text{ lorsque } R_c \gg L\omega,\ et$$

$$V_S = \frac{\mu\, S\, H\, R_c}{L} \text{ lorsque } R_c \ll L\omega$$

où j est défini par la relation j²=-1, μ représente la perméabilité magnétique du milieu considéré, et ω la fréquence angulaire du champ $\vec{H}$.

A partir de la tension de sortie induite $V_S$, on en déduit à l'aide des relations précédentes, la valeur du champ magnétique $\vec{H}$. On entend par valeur du champ magnétique, la valeur du champ obtenue selon l'axe du détecteur.

La fréquence de coupure basse pour laquelle $V_S$ est atténué de 3 db est telle que

$$F_b = \frac{1}{2\pi\theta}$$

ou

$$\omega_b = 2\pi F_b = \frac{1}{\theta},$$

$\omega_b$ représentant la fréquence angulaire de coupure basse. Pour les fréquences plus basses que $F_b$, $V_S$ subit une atténuation de 6 db par octave.

2

Ainsi, lorsque $R_c \gg L\omega$, la constante de temps $\theta$ est très petite et de ce fait la fréquence de coupure basse $F_b$ est très élevée. En revanche, lorsque $R_c \ll L\omega$, la fréquence de coupure basse $F_b$ est faible mais la tension de sortie $V_s$ est presque nulle et ne permet pas d'en déduire la valeur du champ magnétique $\vec{H}$. La largeur de la bande passante des détecteurs connus est donc très limitée.

Les détecteurs de champ magnétique connus de l'art antérieur sont généralement de type cylindrique ou semicylindrique. Dans le premier cas, ils ne sont par références, c'est-à-dire qu'ils ne sont pas portés à un potentiel de référence, et dans le deuxième cas, ils sont référencés par rapport à la masse. Les conducteurs de ces détecteurs sont couplés ensemble générale-ment sur une résistance de charge $R_c$ de 50 $\Omega$. Ces détecteurs ont une constante de temps B de l'ordre de 2 à 5 ns et donc une fréquence de coupure basse $F_b$ élevée, de l'ordre de 30 MHz à 80 MHz. D'autre part, la fréquence de coupure haute $F_h$ est comprise dans l'intervalle 200 MHz à 500 MHz. Le rapport $F_h/F_b$ entre la fréquence haute et la fréquence basse ne dépasse pas la valeur 6, la bande passante en fréquence de ces détecteurs est étroite.

Or, pour l'étude notamment des perturbations par des parasites électromagnétiques, les détecteurs de champ magnétique doivent pouvoir détecter directement des signaux électromagnétiques de forme quelconque dont le spectre de fréquence est étendu (20 kHz à 300 MHz).

D'autre part, les déplacements de charges électriques, dues à la composante électrique du champ électromagnétique, dans lequel se trouvent les détecteurs de champ magnétique, induisent dans les spires conductrices insuffisamment blindées de ces détecteurs des signaux parasites.

Plus les fréquences de travail des détecteurs sont élevées, plus les signaux parasites, dus à l'action du champ électrique $\vec{E}$, sont du même ordre de grandeur que les signaux correspondant à l'action du champ magnétique $\vec{H}$, ce qui nuit à la qualité de la détection.

La figure 2 représente schématiquement une spire coaxiale dite de "Moebius", connue de l'homme de l'art, permettant justement de mesurer un champ magnétique $\vec{H}$ en rejetant les effets dus au champ électrique $\vec{E}$ grâce à l'utilisation d'un câble coaxial ayant une gaine suffisamment blindée.

Cette spire est formée par un enroulement d'un câble coaxial 13 coupé en deux parties en son milieu 9; ces deux parties sont reliées de façon à ce que la gaine 6 de la première moitié soit connectée à l'âme 8' de la seconde moitié et que l'âme 8 de la première moitié soit connectée à la gaine 6' de la seconde moitié. Cette inversion ne modifie pas la structure coaxiale du câble. Les gaines 6, 6' respectivement des deux extrémités 5, 5' restées libres sont reliées ensemble pour former un point commun C de référence. Chacune des deux âmes 8, 8' qui aboutit à une de ces extrémités 5, 5' est chargée par une résistance de charge $R_c$ connectée entre l'âme considérée et le point commun C de référence. On a donc deux résistances de charge $R_c$. Ces deux résistances sont égales et leur valeur est la même que celle de l'impédance caractéristique du câble coaxial 13, généralement de 50$\Omega$. On constitue ainsi deux demi-spires symétriques.

Lorsqu'un champ magnétique $\vec{H}$ traverse le plan formé par cette spire, il crée un courant induit $\vec{I}$ dans chaque demi-spire, dont le sens dépend de celui du champ magnétique $\vec{H}$ et obéit à la règle dite "d'Ampère". Les tensions induites dans les gaines 6, 6' (respectivement dans les âmes 8, 8') de chaque demi-spire sont symétriques. La gaine 6, 6' de chaque demi-spire est donc couplée électriquement à l'âme 8, 8' de l'autre demi-spire. Cette spire avec les deux charges $R_c$ constitue un 8 replié sur lui-même ou boucle infinie. Cet arrangement imaginé par l'inventeur Moebius permet de "déployer" un câble coaxial pour permettre à l'induction de développer une tension $V_s$ entre la gaine et l'âme. Cette tension $V_s$ permettant de calculer la valeur du champ magnétique $\vec{H}$ est mesurée indifféremment aux bornes d'une des résistances de charge $R_c$.

Ainsi, cette spire coaxiale de Moebius en présence d'un champ magnétique $\vec{H}$, se comporte comme deux générateurs de tension symétriques. Elle est adaptée sur son impédance caractéristique et blindée par rapport au champ électrique $\vec{E}$.

La réjection du champ électrique $\vec{E}$ pour une fréquence donnée est d'autant meilleure que les dimensions de la spire sont réduites et que l'impédance de transfert du câble coaxial utilisé est plus faible. Pour satisfaire ce dernier point, on utilise généralement dans l'art antérieur un câble coaxial à gaine métallique pleine, au moins de moyenne immunité. L'immunité d'un câble est définie par la capacité de celui-ci à empêcher l'induction de signaux électromagnétiques sur son âme. Un câble de moyenne immunité est par exemple un câble coaxial dont la gaine est réalisée en alternant des tresses de cuivre avec des rubans de mumétal, notamment trois tresses de cuivre alternées avec deux rubans de mumétal.

Ce détecteur de champ magnétique, formé par une spire de Moebius rejette donc l'effet parasite du

champ électrique $\vec{E}$, cet effet parasite étant important, aux fréquences élevées. Par contre, ce détecteur a une bande passante en fréquence comparable aux détecteurs décrits précédemment, c'est-à-dire étroite, les fréquences de coupures basses étant de ce fait élevées.

L'invention a justement pour objet un détecteur de champ magnétique à large bande passante en fréquence permettant de travailler avec des fréquences basses faibles de l'ordre de 20 à 600 KHz et des fréquences hautes, environ de 80 à 300 MHz, sans pour cela être associé à des moyens électroniques intégrateurs. Ce détecteur permet en outre de rejeter l'effet parasite du champ électrique $\vec{E}$.

De façon plus précise, l'invention concerne un détecteur de champ magnétique, caractérisé en ce qu'il comprend au moins un barreau d'un matériau ferromagnétique autour duquel sont enroulées plusieurs spires d'un câble coaxial conducteur coupé en son milieu en une première et une seconde parties, ces parties étant reliées de façon que la gaine de la première partie soit connectée à l'âme de la seconde partie et que la gaine de la seconde partie soit connectée à l'âme de la première partie, chacune des deux extrémités libres du câble servant à mesurer la tension de sortie de ce détecteur.

Selon un mode de réalisation du détecteur de champ magnétique, le nombre de spires de part et d'autre de la coupure du câble coaxial est identique et dépend du domaine de fréquences étudié.

De préférence, le câble coaxial a une impédance caractéristique allant de 10 à 50Ω.

Selon un autre mode de réalisation du détecteur de champ magnétique, le détecteur comprend un enrobage isolant dans lequel sont logés le barreau et le câble coaxial, les deux extrémités du câble coaxial étant connectées chacune à une borne coaxiale distincte, les gaines de ces deux extrémités étant en outre reliées entre elles par une plaque métallique commune, la plaque et les deux bornes coaxiales étant accessibles hors de l'enrobage.

De façon avantageuse, le câble coaxial du détecteur de champ magnétique est à gaine métallique pleine pour qu'il ait une bonne immunité, notamment lorsque le détecteur fonctionne à des fréquences supérieures à 100 MHz ; mais bien entendu, on peut utiliser d'autres types de câbles coaxiaux tels que des câbles coaxiaux à gaines multiples souples, notamment pour des fréquences situées entre 20 kHz et 80 MHz.

De préférence, le détecteur de champ magnétique comprend plusieurs barreaux ferromagnétiques, le nombre de ces barreaux étant fonction notamment du domaine de fréquence étudié.

De façon avantageuse, ces barreaux ferromagnétiques sont réalisés en des matériaux différents. Un matériau de perméabilité magnétique μ faible (de l'ordre de 250) permet de travailler en haute fréquence et un matériau de perméabilité magnétique μ élevée (environ 1600), en basse fréquence.

Selon un mode préféré de réalisation du détecteur de champ magnétique, le barreau ferromagnétique est en ferrite.

Selon un autre mode préféré de réalisation du détecteur de champ magnétique, le nombre de spires du câble coaxial va dans l'intervalle de 2 à 50, le nombre de spires étant fonction du domaine de fréquence étudié.

D'autres caractéristiques et avantages de l'invention ressortiront mieux de la description qui va suivre, donnée à titre purement illustratif et non limitatif. La description est faite en référence aux figures 1 à 3 annexées dans lesquelles :

- la figure 1, déjà décrite, représente schématiquement une spire d'un conducteur permettant de détecter un champ magnétique de façon connue,
- la figure 2, déjà décrite, représente schématiquement un détecteur de champ magnétique connu, formé par une spire coaxiale de Moebius, et
- la figure 3 représente schématiquement un exemple de détecteur de champ magnétique selon l'invention.

Sur la figure 3 sont représentés trois barreaux 1 ferromagnétiques autour desquels sont enroulées huit spires 4 ou enroulements d'un câble coaxial conducteur, coupé en son milieu 9 de façon à former une inversion du même type que celle de la spire dite de "Moebius". Ainsi, le câble coaxial est coupé en son milieu au niveau de la référence 9 en deux moitiés, la gaine de la première moitié étant reliée à l'âme de la seconde moitié et l'âme de la première moitié étant reliée à la gaine de la seconde moitié.

Ce câble est enroulé généralement sur une matrice isolante que l'on n'a pas représentée pour plus de clarté. Cette matrice peut être de forme quelconque, par exemple cylindrique, les barreaux étant placés au centre de la matrice suivant son axe longitudinal.

Par ailleurs, on a représenté figure 3 des spires circulaires enroulées régulièrement mais cet exemple n'est bien entendu pas limitatif. En effet, les spires peuvent être de forme quelconque, elles épousent la forme de la matrice sur laquelle elles sont enroulées et elles peuvent être réparties suivant un pas quelconque et même variable.

Les deux extrémités libres 5, 5' de ce câble sont connectées respectivement à des bornes coaxiales 7, 7' ; l'âme et la gaine de chaque extrémité du câble sont reliées respectivement à l'âme et à la gaine de la borne coaxiale qui leur est associée. Les gaines des deux extrémités 5, 5' sont en outre reliées entre elles par une plaque métallique commune 15 par exemple en cuivre. Chaque borne coaxiale est reliée à une

résistance de charge $R_c$ du même type que celles représentées en figure 2, et égale à l'impédance caractéristique du câble coaxial. Chacune de ces deux bornes coaxiales 7, 7' permet de mesurer la tension de sortie induite $V_S$ de ce détecteur en présence d'un champ magnétique $\vec{H}$.

Cet exemple de réalisation n'est bien entendu par limitatif, on peut en effet relier en outre directement les deux extrémités de la gaine ensemble, en amont de leur connexion à la plaque métallique 15. Ce mode de connexion est avantageux car il permet de préserver la continuité de la structure coaxiale du câble, notamment lorsque les bornes coaxiales 7, 7' sont éloignées l'une de l'autre.

L'ensemble comprenant les barreaux 1 et les enroulements 4 du câble coaxial est placé dans un enrobage 11 d'une matière isolante non corrosive telle que du plastique. Seules les extrémités 5, 5' du câble coaxial sont accessibles hors de cet enrobage 11 par l'intermédiaire des bornes coaxiales 7, 7' et de la plaque métallique 15.

Le détecteur ainsi formé peut être placé dans un milieu de travail quelconque et notamment dans l'air.

Lorsque le détecteur de champ magnétique conforme à l'invention est placé dans un champ magnétique $\vec{H}$, les lignes de force de ce champ traversent le détecteur suivant les directions formées par les barreaux 1 ferromagnétiques. Ce champ magnétique $\vec{H}$ induit alors un courant électrique $\vec{I}$ qui parcourt les enroulements 4 du câble coaxial. Le sens de parcourt du courant $\vec{I}$ dépend du sens du champ magnétique $\vec{H}$; il obéit à la règle dite "d'Ampère". La tension de sortie induite $V_S$ mesurée indifféremment à l'une des deux extrémités 5, 5' du câble coaxial, par l'intermédiaire respectivement des bornes coaxiales 7, 7' auxquelles elles sont connectées, permet d'en déduire la valeur du champ magnétique $\vec{H}$. Il est bien entendu que si l'on prend la tension de sortie entre les deux bornes coaxiales 7 et 7', on obtient une tension égale à $2V_S$ à condition de relier les deux bornes coaxiales 7 et 7' sur une résistance de charge de $4R_c$.

Dans le détecteur conforme à l'invention, l'utilisation d'une inversion du même type que celle de la spire de Moebius, avec des enroulements d'un câble coaxial de moyenne immunité, tel qu'un câble coaxial à gaine métallique pleine, permet de rejeter l'effet parasite du champ électrique $\vec{E}$.

De plus, l'utilisation de plusieurs spires 4 enroulées autour de barreaux 1 ferromagnétiques permet d'augmenter la valeur de l'inductance propre L du détecteur et donc d'augmenter la constante de temps $\theta = L/R_c$ de ce détecteur. L'augmentation de $\theta$ entraîne une diminution de la fréquence de coupure basse $F_b = 1/2\pi\theta$. La figure 3, sur laquelle on a représenté huit spires 4 et trois barreaux 1 n'est qu'un exemple de réalisation. On aurait pu utiliser plus ou moins de spires et plus ou moins de barreaux.

L'utilisation de plusieurs spires permet d'augmenter l'inductance L de l'ensemble du détecteur par effet d'auto-induction L' entre spires. En effet, l'auto-induction L' est proportionnelle au carré du nombre de spires. Le nombre de spires 4 conditionne de ce fait la valeur de la fréquence de coupure basse $F_b$ du détecteur. L'augmentation de l'induction L de l'ensemble du détecteur par auto-induction est limitée du fait de l'utilisation d'une inversion du même type que celle de la boucle de Moebius qui sépare en deux demibobinages les spires 4 pour constituer deux générateurs de tension symétriques. De ce fait, on utilise avantageusement de 2 à 50 spires.

L'introduction de barreaux 1 ferromagnétiques au centre des enroulements 4 du câble coaxial permet également d'augmenter l'inductance L de l'ensemble du détecteur, tout en homogénéisant les constantes de couplages créées par les spires 4. En effet, les phénomènes de couplage entre le champ magnétique $\vec{H}$ et chaque spire 4 sont perturbés par les effets de couplage entre les différentes spires utilisées, ce qui a pour conséquence de limiter sensiblement la fréquence de coupure haute $F_h$.

L'introduction de barreaux 1 ferromagnétiques canalise les lignes de force suivant la direction de ces barreaux 1 et amplifie celles-ci. Ces barreaux 1 permettent donc d'homogénéiser les constantes de couplage et d'augmenter l'induction L de l'ensemble du détecteur par la perméabilité magnétique propre aux barreaux 1.

L'augmentation de l'induction L en fonction du nombre de barreaux tend vers une valeur limite en raison de la réluctance importante présentée par le circuit magnétique ouvert du détecteur de l'invention.

Les barreaux 1 ferromagnétiques utilisés peuvent présenter des diamètres et des longueurs différents suivant le fabricant, seul le volume de ces barreaux influe sur l'induction L du détecteur. Le nombre de barreaux 1 utilisé dépend donc notamment du volume respectif de ces barreaux et du volume interne de la matrice sur laquelle le câble coaxial est enroulé.

De plus, suivant le type de matériaux ferromagnétiques utilisé pour former ces barreaux, on peut étudier différents domaines de fréquences. Ainsi, un matériau ferromagnétique de perméabilité magnétique $\mu$ faible, de l'ordre de 250, permet de travailler dans les hautes fréquences, tandis qu'un matériau ferromagnétique de $\mu$ élevé, de l'ordre de 1600, permet de travailler dans les basses fréquences.

Comme on l'a vu précédemment, la constante de temps $\theta$ d'un détecteur est égale à $L/R_c$. On peut donc, en réduisant l'impédance caractéristique du câble coaxial et la résistance de charge $R_c$, augmenter également la constante de temps $\theta$ du détecteur et donc diminuer la fréquence de coupure basse. Cette impé-

dance caractéristique, généralement de 50Ω, est de ce fait choisie de façon préférentielle inférieure, par exemple de l'ordre de 10Ω.

Ainsi, les détecteurs conformes à l'invention présentent des bandes passantes en fréquence élargies vers les fréquences de coupure basses, par rapport aux bandes passantes en fréquence des détecteurs de l'art antérieur. Les fréquences de coupure basses des détecteurs conformes l'invention, ont été divisées par un coefficient allant environ de 100 à plus de 500, par rapport aux fréquences de coupure basses des détecteurs de l'art antérieur, sans pour autant diminuer de façon nuisible leurs fréquences de coupures hautes.

Les détecteurs conformes à l'invention, présentent ainsi les principales caractéristiques suivantes :
- $\theta$ compris entre environ 250 ns et 8 µs,
- $F_h$ compris entre environ 80 MHz et 300 MHz,
- $F_b$ compris entre environ 20 kHz et 600 kHz,
- $F_h/F_b$ compris entre environ 500 et 4000.

Ces caractéristiques dépendent, comme on l'a vu précédemment, notamment de l'inductance L du détecteur et de l'impédance caractéristique $R_c$ du câble coaxial, l'inductance L étant fonction du nombre de spires, du nombre de barreaux et de la nature des matériaux magnétiques.

Si on prend par exemple un câble coaxial ayant une impédance caractéristique de 50Ω, que l'on enroule de façon conforme à l'invention suivant huit spires de diamètre environ 4 cm autour de trois barreaux ferromagnétiques dont deux d'entre eux ont 20 cm de longueur, 1 cm de diamètre et une perméabilité magnétique de 250 et dont le troisième a 15 cm de longueur, 1,5 cm de diamètre et une perméabilité magnétique de 1600, on obtient une fréquence de coupure basse de l'ordre de 200 kHz et une fréquence de coupure haute de l'ordre de 200 MHz.

Suivant un autre exemple, si on prend un câble coaxial ayant une impédance caractéristique de 15Ω que l'on enroule de façon conforme à l'invention suivant 21 spires de 4 cm de diamètre autour de sept barreaux dont six d'entre eux ont 20 cm de longueur, 1 cm de diamètre et une perméabilité magnétique de 250 et dont le septième a une longueur de 15 cm, un diamètre de 1,5 cm et une perméabilité magnétique de 1600, on obtient une fréquence de coupure basse de l'ordre de 20 kHz et une fréquence de coupure haute de l'ordre de 80 MHz. Le rapport $F_h/F_b$ résultant est de l'ordre de 4000 ; ce rapport est considérable en comparaison du rapport d'environ 1200 que l'on aurait obtenu dans les mêmes conditions en utilisant un câble coaxial de gaine identique et d'impédance caractéristique de 50Ω, et surtout en comparaison du rapport 6 obtenu avec des détecteurs de champ magnétique de l'art antérieur.

Avec deux détecteurs conformes à l'invention conjugués, on peut donc travailler dans un domaine de fréquence allant de 20 kHz à 300 MHz.

Les détecteurs de champ magnétique conformes à l'invention sont très simples à réaliser. Ils permettent de rejeter l'effet parasite du champ électrique $\overrightarrow{E}$ et de travailler dans un grand domaine de fréquences, notamment à des fréquences basses pouvant descendre en-dessous de 20 kHz. De plus, le fait de ne pas utiliser de dispositif électronique sophistiqué et de source d'énergie lui procure une autonomie illimitée. Ces avantages sont notamment intéressants dans le cas particulier où ces détecteurs sont utilisés par exemple pour contrôler les signaux électromagnétiques émis par des simulateurs, pour détecter des parasites électromagnétiques de toute provenance et pour déterminer l'efficacité d'un blindage électromagnétique de dispositifs électroniques.

## Revendications

Détecteur de champ magnétique comprenant au moins un matériau magnétique autour duquel sont enroulées plusieurs spires (4) d'un câble coaxial conducteur blindé, caractérisé en ce que le câble est coupé en son milieu (9) en une première et une seconde parties, ces parties étant reliées de façon que la gaine de la première partie soit connectée directement à l'âme de la seconde partie et que la gaine de la seconde partie soit connectée directement à l'âme de la première partie, chacune des deux extrémités libres (5, 5') du câble servant à mesurer la tension de sortie de ce détecteur, et en ce que le matériau est ferromagnétique et a la forme d'un barreau (1).

2. Détecteur de champ magnétique selon la revendication 1, caractérisé en ce que le nombre de spires (4) de part et d'autre de la coupure (9) du câble coaxial est identique et dépend du domaine de fréquences étudié.

3. Détecteur de champ magnétique selon l'une quelconque des revendications 1, caractérisé en ce que le câble coaxial a une impédance caractéristique allant de 10 à 50 Ω.

4. Détecteur de champ magnétique selon la revendications 1, caractérisé en ce qu'il comprend un enrobage (11) isolant dans lequel sont logés le barreau (1) et le câble coaxial, les deux extrémités (5, 5') du câble coaxial étant connectées chacune à une borne coaxiale distincte (7, 7'), les gaines de ces deux extrémités (5, 5') étant en outre reliées entre elles par une plaque métallique commune (15), la plaque (15) et les deux bornes coaxiales (7, 7') étant accessibles hors de l'enrobage (11).

5. Détecteur de champ magnétique selon la revendication 1, caractérisé en ce que le câble coaxial est à gaine métallique pleine.

EP 0 206 879 B1

6. Détecteur de champ magnétique selon la revendication 1, caractérisé en ce qu'il comprend plusieurs barreaux (1).

7. Détecteur de champ magnétique selon la revendication 6, caractérisé en ce que les barreaux (1) sont réalisés en des matériaux ferromagnétiques différents.

8. Détecteur de champ magnétique selon la revendication 1, caractérisé en ce que le barreau (1) est en ferrite.

9. Détecteur de champ magnétique selon la revendication 1, caractérisé en ce que le nombre de spires (4) du câble va de 2 à 50.

10. Détecteur de champ magnétique selon l'une quelconques des revendications 5 à 9, caractérisé en ce que les deux extrémités (5, 5') libres du câble coaxial sont connectées chacune à une borne coaxiale distincte (7, 7'), les extrémités libres de la gaine de chaque partie du câble étant reliés directement.


## Claims

1. Magnetic field detector comprising at least one magnetic material about which are wound several turns (4) of a shielded conductive coaxial cable, characterized in that the latter is cut in its centre (9) into first and second portions, said portions being connected in such a way that the sheath of the first portion is connected directly to the core of the second portion and the sheath of the second portion is connected directly to the core of the first portion, each of the two free ends (5, 5') of the cable being used for measuring the output voltage of the detector and in that the material is ferromagnetic and shaped like a bar (1).

2. Magnetic field detector according to claim 1, characterized in that the number of turns (4) on either side of the coaxial cable break (9) is identical and is dependent on the frequency range investigated.

3. Magnetic field detector according to claim 1, characterized in that the coaxial cable has a characteristic impedance between 10 and 50 Ω.

4. Magnetic field detector according to claim 1, characterized in that it comprises an insulating covering (11) in which are located the bar (1) and the coaxial cable, the two ends (5, 5') of the coaxial cable being in each case connected to a separate coaxial terminal (7, 7'), the tubes of said two ends (5, 5') also being interconnected by a common metal plate (15), the plate (15) and the two coaxial terminals (7, 7') being accessible outside the covering (11).

5. Magnetic field detector according to claim 1, characterized in that the coaxial cable has a solid methal sheath.

6. Magnetic field detector according to claim 1, characterized in that it comprises several bars (1).

7. Magnetic field detector according to claim 6, characterized in that the bars (1) are made from different ferromagnetic materials.

8. Magnetic field detector according to claim 1, characterized in that the bar (1) is made from ferrite.

9. Magnetic field detector according to claim 1, characterized in that the cable has 2 to 50 turns (4).

10. Magnetic field detector according to any one of the claims 5 to 9, characterized in that the two free ends (5, 5') of the coaxial cable are each connected to a separate coaxial terminal (7, 7'), the free ends of the sheath of each part of the cable being directly connected.


## Patentansprüche

1. Magnetfelddetektor mit wenigstens einem magnetischen Material, um welches mehrere Windungen (4) eines abgeschirmten, leitenden Koaxialkabels aufgewickelt sind, dadurch gekennzeichnet, daß das Kabel in seiner Mitte (9) in einen ersten und einen zweiten Teil durchschnitten ist, wobei diese Teile derart miteinander verbunden sind, daß die Scheide des ersten Teil direkt mit der Seele des zweiten Teils verbunden ist und daß die Scheide des zweiten Teils direkt mit der Seele des ersten Teils verbunden ist, wobei jedes der beiden freien Kabelenden (5, 5') zur Messung der Ausgangsspannung dieses Detektors dient, und daß das Material ferromagnetisch ist und die Form eines Stabs (1) hat.

2. Magnetfelddetektor nach Anspruch 1, dadurch gekennzeichnet, daß die Zahl der Windungen (4) auf der einen und der anderen Seite des Schnittes (9) des Koaxialkabels identisch ist und von dem untersuchten Frequenzbereich abhängt.

3. Magnetfelddetektor nach Anspruch 1, dadurch gekennzeichnet, daß das Koaxialkabel eine charakteristische Impedanz von 10 bis 50 Ω besitzt.

4. Magnetfelddetektor nach Anspruch 1, dadurch gekennzeichnet, daß er eine isolierende Verkleidung (11) aufweist, in der der Stab und das Koaxialkabel angeordnet sind, wobei die beiden Enden (5, 5') des Koaxialkabels jeweils mit einer unterschiedlichen Koaxialklemme (7, 7') verbunden sind, wobei die Scheiden dieser beiden Enden (5, 5') außerdem miteinander über eine gemeinsame Metallplatte (15) verbunden sind, wobei die Platte (15) und die beiden Koaxialklemmen (7, 7') außerhalb der Verkleidung zugänglich sind.

5. Magnetfelddetektor nach Anspruch 1, dadurch gekennzeichnet, daß das Koaxialkabel eine vollmetallische Scheide besitzt.

6. Magnetfelddetektor nach Anspruch 1, dadurch gekennzeichnet, daß er mehrere Stäbe (1) aufweist.

7. Magnetfelddetektor nach Anspruch 6, dadurch gekennzeichnet, daß die Stäbe (1) aus verschiedenen ferromagnetischen Materialien bestehen.

8. Magnetfelddetektor nach Anspruch 1, dadurch gekennzeichnet, daß der Stab (1) aus Ferrit besteht.

9. Magnetfelddetektor nach Anspruch 1, dadurch gekennzeichnet, daß die Zahl der Kabelwindungen zwischen 2 und 50 liegt.

10. Magnetfelddetektor nach einem der Ansprüche 5 bis 9, dadurch gekennzeichnet, daß die beiden freien Enden (5, 5') des Koaxialkabels jeweils mit einer unterschiedlichen Koaxialklemme (7, 7') verbunden sind, wobei die freien Enden der Scheide jedes Teils des Kabels direkt miteinander verbunden sind.

FIG. 1

FIG. 2

FIG. 3